# EUROPEAN PATENT APPLICATION

(11) **EP 4 431 965 A1**
(43) Date of publication of application: **18.09.2024**
(21) Application number: 23382240.2
(22) Date of filing: 14.03.2023
(51) Int. Cl.: G01R 33/30, G01N 24/08

(54) **A METHOD FOR OBTAINING A SIGNAL FROM AN ANALYTE BY NUCLEAR MAGNETIC RESONANCE**

(71) Applicant: Fundació Institut de Bioenginyeria de Catalunya, 08028 Barcelona (ES); Oxford Instruments Nanotechnology Tools Limited, Abingdon, Oxfordshire OX13 5QX (GB); Multiwave Technologies AG, 1228 Geneva (CH)
(72) Inventor: MARCO RIUS, Irene, 08028 BARCELONA (ES); PATEL, Hetal, ABINGDON, OX13 5QX (GB); FALLON, Matthew, ABINGDON, OX13 5QX (GB); PORTELA OTAÑO, Alejandro, 08173 SANT CUGAT DEL VALLÈS (ES); YESTE LOZANO, José, 08520 LES FRANQUESES DEL VALLÈS (ES); DUBOIS, Marc, 13013 MARSEILLE (FR); ANTONAKAKIS, Tryfon, 1228 PLAN LES OUATES (CH)
(74) Representative: ZBM Patents - Zea, Barlocci & Markvardsen

(57) **Abstract**

Method for obtaining a signal from an analyte by nuclear magnetic resonance (NMR), comprising providing a microfluidic chip comprising a measuring chamber for an analyte; placing an analyte in the measuring chamber of the chip; placing the chip in a carrier, the chip or the carrier comprising a radiofrequency coil, so that the radiofrequency coil is placed inside the measuring chamber of the chip; placing the carrier in an NMR apparatus so that the measuring chamber of the chip is accommodated in a target area of the apparatus, the apparatus being configured for applying magnetic field gradients in the target area, and for applying radiofrequency pulses towards the target area; injecting a substrate into the measuring chamber containing the analyte; applying a magnetic field gradient to the measuring chamber; and applying radiofrequency pulses to the measuring chamber, obtaining a signal from the analyte through the radiofrequency coil.

## Description

The present disclosure relates to a method for obtaining a signal from an analyte with a substrate agent, for example a hyperpolarized substrate agent, by nuclear magnetic resonance (NMR), a carrier for a microfluidic chip, and a kit comprising a carrier and a microfluidic chip. In particular, the disclosure pertains to systems and components for obtaining a signal for the analysis of a physiological condition in an analyte using nuclear magnetic resonance (NMR).

### BACKGROUND

Nuclear magnetic resonance (NMR) spectrometry is an analytical technique to study the physical, chemical, and biological properties of matter, for example to determine the molecular structure, cellular metabolism or reaction dynamics at the atomic level of a sample, such as phase changes, conformational and configurational alterations, solubility, and diffusion potential. The matter to study in a spectroscopy is referred to as an analyte. An analyte may be any sample, including cells, molecules, compounds and mixtures or any other matter. The analysis of this matter is useful for identifying human disorders.

NMR spectrometry is performed in NMR apparatus. The NMR apparatus comprises a magnet unit and a magnetic unit that apply magnetic gradient pulses to an analyte placed in a target area of the NMR apparatus. It is common to perform spectrometry by placing cell culture comprising the analyte in one or more test tubes and placing the test tubes in the housing of the NMR apparatus so that the analyte is placed in the target area. Then, a magnetic gradient pulse is applied to the target area where the analyte is placed, affecting the spins on the analyte and generating an NMR spectrum that is read by the apparatus and later analysed to know the composition and characteristics of the analyte.

The introduction of the tests tubes into the NMR apparatus is usually performed by introducing the tubes into a probe of the apparatus located such that the analyte, molecules or cells inside the tubes are located in the target area of the apparatus.

One problem with NMR spectrometry using test tubes is the need to define accurately the amount of sample to be placed on the test tube. Another problem is that the interaction between different samples cannot be observed and monitored in real time. In addition, there is limited access to the sample, and it is very difficult to put the samples into the tube and take them out for their measuring, and the process is cumbersome.

### SUMMARY

In a first aspect, a method for obtaining a signal from an analyte with a substrate agent, for example a hyperpolarized substrate agent, by nuclear magnetic resonance (NMR) is provided. In a second aspect, a carrier for a microfluidic chip is provided. In a third aspect, a kit comprising a carrier and a microfluidic chip is disclosed. In a fourth aspect, a microfluidic chip is disclosed.

The method comprises:
a) providing a microfluidic chip comprising a measuring chamber for an analyte;
b) placing an analyte in the measuring chamber of the microfluidic chip;
c) placing the microfluidic chip in a carrier, the microfluidic chip or the carrier comprising a radiofrequency coil, so that the coil is placed inside the measuring chamber of the microfluidic chip;
d) placing the carrier in an NMR apparatus so that the measuring chamber of the microfluidic chip is accommodated in a target area of the apparatus, the apparatus being configured for applying magnetic field gradients in the target area, and for applying radiofrequency (RF) pulses towards the target area;
e) injecting a substrate agent into the measuring chamber containing the analyte. This injection generates a detection complex in the measuring chamber, the detection complex comprising the analyte and the substrate;
f) applying a magnetic field gradient to the measuring chamber; and
g) applying radiofrequency pulses to the measuring chamber, obtaining a signal from the analyte through the radiofrequency coil.

The nuclei of an analyte can align with the static magnetic field (B0) generated by the magnet unit of the NMR apparatus in two possible orientations: a first position or alpha state where the nuclei align with the B0 field, and a second position or beta state where the nuclei align against the B0 field. The application of radiofrequency pulses to the measuring chamber is done by the apparatus through the radiofrequency coil. The coil transmits a radiofrequency pulsatile signal to the analyte. The coil also generates a B1 magnetic field in the measuring chamber. This B1 magnetic field is a transverse field with an opposite direction than B0. When the radiofrequency coil transmits a radiofrequency pulsatile signal to the analyte, the nuclei switch from alpha to beta state. When the radiofrequency signal is turned off during the pulse, the nuclei relax to low-energy state alpha in a precession process at a determined frequency. This switch from beta to alpha states generates a current within the coil, which is the signal obtained by the apparatus through the coil Therefore, the pulsatile signal excites nuclear spins and signals are obtained from excitation of those nuclear spins. The frequency of the pulses is selected depending on the characteristics of the spins of the atoms of the analyte.

The method disclosed herein eases the placement of the samples into the apparatus, making easier to place and to remove the samples and analytes from the carrier and from the microfluidic chip in comparison with methods known in the state of the art where test tubes are used to obtain the signal. In particular, the use of a microfluidic chip allows for an easier placing of the microfluidic chip into the apparatus and provides a better environment to monitor the signals and pulses emitted and transmitted than using test tubes, which incurs in a better signal, than in turn incurs in a later more accurate analysis of the analytes. The present disclosure is therefore a more efficient method of obtaining a signal from an analyte in known NMR spectrometer apparatuses. As existent apparatuses can be used, the method has a low economic cost.

The method of the invention allows the position of the measuring chamber of the microfluidic chip, and therefore the analyte, at a predetermined position inside the apparatus in order to obtain a better signal.

Preferably, the method may further comprise analyzing the signal received by the coil. This analysis may be done by a computer or by any other method, generating an NMR spectrum. This analysis may comprise determining a physiological, chemical, and/or biological condition of an analyte, such as specific molecules of those analytes.

The method may further comprise injecting cell media into the measuring chamber comprising the analyte. This cell media helps keeping the sample matrix healthy. This injection may be injected by a cell media opening acting as an inlet and removed via a cell media opening acting as an outlet. This injection may be done in a closed circuit.

The "measuring chamber" defined in this disclosure is a chamber configured to place an analyte therein. This measuring chamber can also be referred to as a "cell chamber", "sample chamber", "detection chamber", "science camber" among others, their use being interchangeable, and the invention should not be limited to any of these terms. This measuring chamber can comprise one or more microfluidic wells. In addition, the expression "a", "an" or "one" can refer to one or more.

The "analyte", or "sample" defined in this disclosure include molecules and healthy and diseased cells of human or animal organs and tissues, human or animal cells (or cell fragments), organoids, corporal fluid from human or animals, whole animals as well as cells and fluids from vegetables. In the present disclosure, the concept of "animal" has to be understood as any kind of animal, included but no limited to humans or animals of any kind.

The analyte may be placed into the microfluidic chip in a "sample matrix" or "scaffold". The sample matrix, or scaffold, is a sample matrix for accommodating an analyte of any known type. For example, the sample matrix can be formed as a three-dimensional construct or as a planar construct, comprise pores, and be of any known material such as carboxymethylcellulose.

The microfluidic chip can comprise more than one measuring chamber. Each measuring chamber can comprise more than one analyte or sample matrix containing the analyte. The microfluidic chip allows the detection of the analyte or sample matrix containing the analyte in a measuring chamber. The signals can be obtained for the analyte placed on the B1 region produced by the radiofrequency coil. The sample in the measuring chamber can be monitored by the NMR apparatus. With this microfluidic chip is possible to detect one well at any given time. Multiple measuring chambers can be connected by microfluidic channels, the NMR detection taking place in a single measuring chamber.

The microfluidic chip can comprise two or more chambers on the microfluidic chip, both two chambers being connected by microfluidic lines on the microfluidic chip. This allows the measurement of the crosstalk effect of two or more different samples at the same time. The probe can also comprise a measuring chamber, therefore having one of the chambers inside the probe and the other one outside the probe. The signal obtained is obtainable when the measuring chamber is placed on the B1 region produced by the radiofrequency coil. The measuring chamber of the microfluidic chip can be detected while being connected to another chamber placed outside the B1 region generated by the radiofrequency coil. In another embodiment, the probe can be adapted to allow the placement of multiple carriers therein.

In a preferred embodiment, the NMR apparatus is an apparatus that comprises shimming circuits. Shimming technology enables the generation of a more homogeneous magnetic field on the apparatus. These shimming circuits are preferred than shimming by using small electrical circuits having some resistance such than in NMR apparatus When current flows in a wire, a magnetic field is generated. These shimming circuits generate small magnetic fields that can be used to adjust the main field applied and increase its homogeneity. The shimming coils can be in the probe, to smooth the field at the target area comprising the analyte. The shimming coils can adjust the magnetic field in several directions. Typically, a user needs to adjust the field in three dimensions whilst measuring a reference peak. This better homogeneity makes peaks easier to identify and to integrate.

Preferably, the nuclear magnetic resonance (NMR) spectrometer apparatus is a benchtop NMR apparatus. Preferably, the NMR apparatus is a planar magnetic field region or an X-Pulse benchtop spectrometer apparatus.

In particular, the apparatus comprises a probe, the probe comprising a seat configured for accommodating the carrier, such that the measuring chamber of the microfluidic chip and the radiofrequency coil are placed in the target area of the apparatus after the carrier is placed in the probe of the apparatus. The NMR apparatus is preferably an NMR apparatus with probe exchangeability capabilities. This type of NMR apparatus is preferable as the same apparatus can be used for different experiments and analysis, exchanging the probe placed therein. The target area defined by the NMR apparatus is an area to which the radiofrequency pulses generated by the radiofrequency pulse generation unit of the NMR apparatus are sent.

The apparatus may also comprise a magnet unit and a magnetic gradient unit, the magnet unit and the magnetic gradient unit being configured for applying one or more magnetic field gradients in the target area, and a radiofrequency (RF) pulse generation unit for applying radiofrequency (RF) pulses towards the target area. In a preferred embodiment, the magnet unit of the apparatus generates an external magnetic field around the sample or analyte.

Preferably, the magnet unit of the apparatus comprises a permanent magnet. This type of magnet offers better stability, ensuring that the experiments are artefact-free. In addition, the permanent magnet makes the peaks of the set of signals transmitted by the coil to be easier to separate, making lower concentrations visible. For example, the permanent magnet may be a 1.4 T (60 MHz for 1H frequency) benchtop NMR spectrometer.

Preferably, the substrate agent is injected into a membrane pump of the microfluidic chip, fluidically connected to the measuring chamber, the membrane pump regulating the flow of substate into the measuring chamber.

The present disclosure also provides a carrier for a microfluidic chip. The carrier comprises a microfluidic chip port to receive the microfluidic chip for the placement therein of a microfluidic chip and an electrical connection from a tuning/matching circuit for interfacing the NMR apparatus. Placing the microfluidic chip into a carrier allows an accurate placement of the analyte on the target area of the NMR apparatus. In addition, by placing the microfluidic chip in a carrier, the microfluidic chip does not interact directly with the apparatus, keeping the sample matrix inside the microfluidic chip healthy.

Preferably, the carrier comprises a main module and a detachable module, the detachable module comprising a docking connector for a radiofrequency coil. This docking connector can alternatively be placed on the apparatus. Preferably, the chip port is defined by the distance, space, chamber or slot between the main module of the carrier and the detachable module of the carrier. Alternatively, the chip port of the carrier may be a housing of the detachable module, a housing of the main module of the carrier, or be a chamber limited by the space between the main module of the carrier and the detachable module.

Preferably, the detachable module of the carrier is a locking cover to releasably lock the microfluidic chip in the chip port. This detachable module is releasably attached to the carrier to lock the microfluidic chip in the chip port. The locking cover eases the placing of the microfluidic chip into the carrier and the removal of the sample matrix or the analytes of a given carrier. This locking cover allows the placement of the microfluidic chip in a carrier to comprise the steps of placing the microfluidic chip in the chip port of the carrier so that the coil is placed attached or in close proximity to the measuring chamber of the chip and closing the locking cover.

In particular, the carrier is adapted for its insertion in a seat of a probe of an NMR apparatus. By placing the carrier inside the probe, the carrier can be configured to be introduced into the probe by sliding the carrier into the probe. Preferably, the carrier comprises an electrical connection from a tuning/matching circuit for interfacing the NMR apparatus, wherein the carrier is adapted for its insertion in a housing of an NMR apparatus.

A problem of a method of analysing an analyte placed on a microfluidic chip without a carrier is that the microfluidic chip cannot be introduced directly into the apparatus as the dimensions of a microfluidic chip for analyzing analytes is usually too small to allow the correct collocation thereof into the apparatus such that the pulses emitted from the apparatus and the signals generated by the coil can be analyzed with accuracy.

Another advantage is that the carrier is reusable and can be placed into the apparatus multiple times, changing the microfluidic chip depending on the sample needed to be measured by using the same carrier. Therefore, the use of a carrier does not imply modifying the apparatus before analysis an analyte. An employer can remove the chip placed on the carrier, place another chip therein, using the same carrier for any quantity of different chips and samples. Alternatively, a different carrier can be used for every different chip.

Another advantage is that the samples and the analytes can be prepared and placed into the microfluidic chip and into the carrier before they are inserted into the NMR apparatus, allowing the preparation of the chips while the NMR apparatus is already working. The chips can also be conditioned outside the apparatus for an extended period of time to allow the progression of a disease or to have the sufficient time for feeding the analytes before entering the apparatus.

In this invention, an inventive chip carrier has been designed for a microfluidic chip. The carrier is adapted for its insertion in an NMR apparatus, in particular to a probe. The carrier is independent of the type of chip and or the type of sample whose signal is intended to be obtained. Preferably, the probe is also designed to fit the carrier therein. The probe also has a mechanical guide to help introduce the carrier into the designated space for the carrier inside the probe. Preferably, the probe is designed such to allow an efficient transfer of energy between the analyte and the probe.

Preferably, the carrier is placed in the apparatus in a position such that the measuring chamber of the microfluidic chip and the coil are placed at the centre of the magnet unit of the apparatus. More preferably, the carrier is configured such that the sample or analyte of the microfluidic chip is placed in at least 0,5 mm from the centre of the magnet. Preferably, the carrier is placed in the apparatus in a position such that a magnetic field generated by the coil is perpendicular to a magnetic field generated by the apparatus. The carrier is configurated so that the analyte is accommodated in the target area of the apparatus so that the magnetic field generated by the coil is perpendicular to the magnetic field generated by the apparatus. This placement allows for a better intensity of the signal and a more accurate measurement.

Preferably, the carrier comprises a housing for tubes connecting at least one openings of the microfluidic chip with the outside of the carrier. An "opening" is defined as an inlet and/or an outlet.

Preferably, the radiofrequency coil is placed in the carrier or in the microfluidic chip such that it is in contact or in close proximity to the measuring chamber of the microfluidic chip once the microfluidic chip is placed on the carrier. The intensity and quality of the signal received improves as the coil is placed closer to the analyteThe radiofrequency coil can also placed at close proximity from the analyte, at a distance as maximum as possible from the analyte so as the signal obtained from the analyte has an adequate intensity and quality. It is understood as "contact" between the coil and the measuring chamber to a contact between the coil and either the walls of the measuring chamber, the analyte, the sample matrix or the detection complex. It is understood as "close proximity" a distance between the coil and the analyte of less than 5 mm, more preferably less than 3 mm, more preferably less than 1 mm, more preferably less than 0.5 mm.

The present invention also discloses a kit comprising a carrier and a microfluidic chip comprising a measuring chamber for the placement therein of an analyte.

The kit comprises a radiofrequency coil placed on the microfluidic chip or on the carrier, placed so that the coil is in contact, attached or in close proximity to the measuring chamber of the microfluidic chip. Preferably, the radiofrequency coil is placed attached to the microfluidic chip. More preferably, the radiofrequency coil is placed inside the measuring chamber of the microfluidic chip. The placement of the coil inside the measuring chamber allows the coil to be in direct contact with the detection complex inside the measuring chamber after the injection of the hyperpolarized substate into the measuring chamber. When the analyte is placed in a sample matrix, the coil may be in direct contact with a sample matrix suspended in the detection complex inside the measuring chamber. The coil may also be placed in direct contact with the inner walls of the measuring chamber. The coil may also form the walls of the measuring chamber. Alternatively, the coil may be placed on the carrier, the coil being in contact with the external walls of the measuring chamber or placed in close proximity of the measuring chamber of a microfluidic chip placed on the chip port of the carrier.

More preferably, the radiofrequency coil comprises conductive tracks e.g. of copper printed on a substrate, the substrate being preferably a printed circuit board (PCB).

Preferably, the radiofrequency coil comprises a radiofrequency coil region, the radiofrequency coil region being the region of the coil that generates the magnetic field, a connecting region for connecting the coil to the power supply or to a docking system to connect it to the power supply, and an intermediate elongated region connecting the radiofrequency coil region to the connecting region. Preferably, the radiofrequency coil is a saddle coil printed on a flexible substrate, more preferably, the radiofrequency region of the coil has a saddle coil pattern, preferably being printed flat and later winded and adjusted to the walls of the cell chamber. The radiofrequency coil region is preferably a cylindrical radiofrequency coil region, preferably having a diameter of between 4 mm and 7 mm-, more preferably having a diameter of 5 mm. A cylindrical radiofrequency coil region is preferred as it generates a stronger magnetic field. Other shapes could also be possible. The measuring chamber of the microfluidic chip is configured to receive a cylindrical radiofrequency region of a radiofrequency coil, preferably the measuring chamber being a cylindric measuring chamber.

Preferably, the substate of the radiofrequency coil has a thickness of between 190 and 250 µm, more preferably 220 µm. Preferably, the layer has a thickness of between 15 and 22 µm, more preferably a thickness of 18 µm. Preferably, the coil comprises a protective polyimide dielectric layer. This protective layer is a thin mask that protects the copper from oxidizing. The connector region does not comprise this thin mask as it requires electrical contact with a complementary connector.

The copper on the radiofrequency region of the radiofrequency coil is placed on the surface of the coil configured to be in direct contact with sample matrix or the liquid placed on the measuring chamber of the microfluidic chip. In the case that the radiofrequency coil region comprises a protective layer, the protective layer is in contact with the detection complex.

Due to the sample matrix being suspended and mixed on the liquid forming a detection complex, the radiofrequency region of the coil can also be in direct contact with the sample matrix. Therefore, the coil may be alternatively configured to be in contact with the sample matrix or scaffold. Alternatively, the coil can be placed on the carrier, such that it is placed in contact or in close proximity with the measuring chamber.

Preferably, the microfluidic chip is a flow-through microfluidic chip. Preferably, the chip comprises a polydimethylsiloxane (PDMS) body. Preferably, it comprises a platform attached to the body, this platform being of a different material than the body, more preferably being a glass platform. An advantage of using chips is that the same chip can also be used in different tests and applications in other machines and not limiting them to tests where a test tube is required.

Preferably, the microfluidic chip comprises a radiofrequency coil, the radiofrequency coil being attached to the microfluidic chip. More preferably, the coil is placed inside the measuring chamber of the coil. The coil, placed inside the measuring chamber, is surrounded by the PDMS body. In a non-preferred embodiment, the coil is embedded in the PDMS body. For example, the radiofrequency coil may form at least part of the walls of the measuring chamber. The radiofrequency coil can be inserted into the measuring chamber during manufacturing, for example as a mould insert. By placing the coil in the mould, after the PDMS body is cured and become rigid the coil is embedded into the PDMS body.

The microfluidic chip may comprise a membrane pump, an opening configured for the injection of a substrate being connected to the membrane pump, and the membrane pump being fluidically connected to the measuring chamber by a fluidic channel, so that the membrane pump inflates upon injection of the substrate and subsequently deflates, delivering the injected substrate towards the measuring chamber though said fluidic channel. The step of injecting a substrate into the measuring chamber containing the analyte may be performed by injecting the substrate into the membrane, which regulates the flow of the substate introduced into the measuring chamber. The microfluidic chip may comprise a serpentine or meandering section placed in the fluidic channel between the membrane and the measuring chamber. Preferably, the meandering section is a capillary meandering section. The resistance allows the membrane to deform and damper the surge in pressure that can take place during the manual injection of substrate agent. The purpose is limiting the peak flow of the substrate agent into the cell chamber. The problem is that a rapid flush of substrate agent can damage or even detach the cells from their sample matrix affecting the correct obtention of the signals.

The microfluidic chip may comprise an additional opening for removing the substrate and air before and after each analysis. The microfluidic chip may preferably comprise four openings, those openings being an inlet configured to inject a substate agent into the measuring chamber, two openings working as an inlet and an outlet to inject cell media into the measuring chamber, and an opening, and an opening configured to extract air or hyperpolarized substate from the measuring chamber. Alternatively, the microfluidic chip may comprise three openings, the opening to inject the substrate agent being also configured as an inlet to inject cell media.

Preferably, the microfluidic chip comprises means for sealing the measuring chamber. Preferably, this means for sealing are removable means for sealing, allowing the introduction and removal of the analytes or sample matrices. In particular, the microfluidic chip may comprise a sealing cover to close the measuring chamber. The sealing cover protects the sample matrix inside the measuring chamber, avoiding the contamination of the matrix during cell culturing and during the measurement of the sample by the NMR apparatus once the microfluidic chip is placed in the NMR apparatus. This sealing cover is adapted to the radiofrequency coil, so that the radiofrequency region of the coil is placed inside the measuring chamber and the rest of the coil is placed outside it. This sealing cover is preferably a glass sealing cover. Materials that can be easily sterilized, such as glass, are preferred because it allows for an easy sterilization. A glass sealing cover is also preferred in a microfluidic chip whose body is made of PDMS material due to the good sealing properties between PDMS and glass. Alternatively, the sealing cover can be of any other suitable material.

The microfluidic chip may also comprise a glass substrate or platform. Preferably, the microfluidic channels and the membrane chamber are defined by the cavity that is formed between the body of the microfluidic chip and the platform substrate when get bonded during manufacturing.

The microfluidic chip may also comprise openings to introduce and to remove cell media. These cell media inlet and outlet allow the feeding of the analyte and the sample matrix inside the measuring chamber. Alternatively, the opening to inject the substrate agent can take the function of the opening working as a cell medium. Therefore, the microfluidic chip may comprise three openings.

It is possible to have more than one measuring chamber in the same microfluidic chip, those sample chambers being connected between them by microfluidic channels. The carrier can also comprise more than one slot for the introduction therein of different microfluidic chips, connected between them by microfluidic lines of the carrier.

The present invention also discloses a microfluidic chip as disclosed above.

### BRIEF DESCRIPTION OF THE DRAWINGS

Non-limiting examples of the present disclosure will be described in the following, with reference to the appended drawings, in which:
Figure 1 is a block diagram of the method, according to an example of the present invention.
Figure 2 is a schematic perspective view of a microfluidic chip according to an example of the present invention.
Figure 3 is an exploded perspective view of the elements of the microfluidic chip on Figure 2.
Figure 4 is a schematic view of a radiofrequency coil according to an example fo the present invention.
Figure 5 is an exploded view of a kit comprising a carrier and a microfluidic chip.
Figure 6 is a perspective view of the kit on Figure 5, comprising a carrier and a microfluidic chip.
Figure 7 is a side view of the kit on Figures 5 and 6, comprising tubes connecting the chip to exterior through the carrier.
Figure 8 is a perspective view of a probe of an NMR apparatus with the kit of Figures 5 to 7 placed therein.

### DETAILED DESCRIPTION OF EXAMPLES

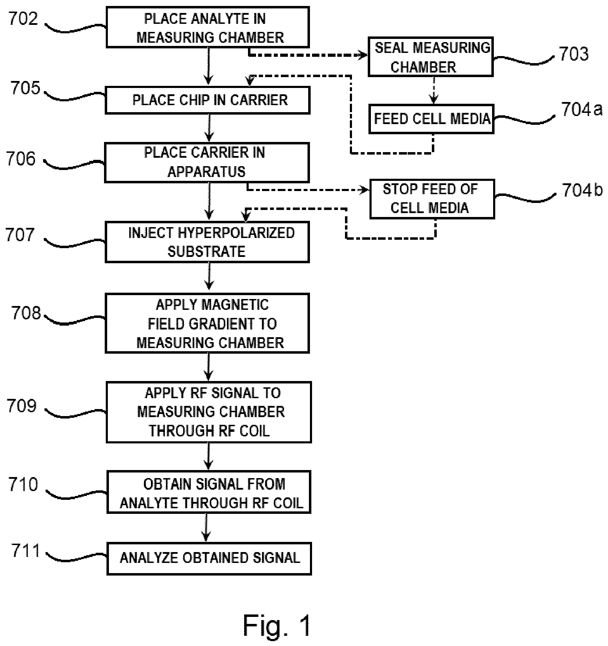

Figure 1 shows a block diagram of the method for obtaining a signal from an analyte according to an example of the present invention. In the example shown, the measuring chamber 11 of the microfluidic chip 1 comprises the radiofrequency coil inside the chamber 11. In an alternate example not shown, the coil 2 is placed on the carrier 3.

Prior to introducing the analyte, molecule, cells, or a sample matrix or scaffold containing them on the measuring chamber 11 of a microfluidic chip 1, or before a second operation sequence the air inside the chamber 11 can be optionally purged by using one of the openings 121 acting as an inlet. Then, the analyte, cells to be measured, or the sample matrix or scaffold containing the analyte is placed (block 702) on the measuring chamber 11.

After the analyte, cells to be measured, or the sample matrix or scaffold containing the analyte are placed inside the chamber 11, the chamber can be optionally sealed (block 703). This sealing may be made by covering the measuring chamber 11 with a sealing cover 111.

After the measuring chamber 11 is sealed, the microfluidic chip 1 can both optionally be kept (block 704a) with a continuous flow of cell media via the openings 122, 123 or can stay without pumping cell medium. The flow can be adjusted externally or stopped for a certain period of time and later reactivated again. The stopping period can be adjusted to be for a period of time such as to keep the condition of the cells in the chamber. The flow of cell media is stopped (block 704b) before injecting (block 707) the dilution into the measuring chamber.

The microfluidic chip comprising the analyte is placed (block 705) in the carrier and then the carrier is placed (block 706) in the apparatus. The carrier is configured so that the analyte in the measuring chamber of the microfluidic chip is accommodated in a target area of the NMR apparatus, the target area being the area designed in the NMR apparatus to where the RF pulses are applied. This carrier allows an accurate placement of the analyte on the target area of the NMR apparatus.

At block 707, the substrate is injected into the measuring chamber of the microfluidic chip. In this embodiment, the substate is a hyperpolarized substrate.

The substrate agent is a liquid. When the substrate reaches the measuring chamber, the analyte and the sample matrix float in this liquid, forming a detection complex. The coil, which is placed inside the measuring chamber, is in direct contact with this detection complex. In an alternate embodiment in which the coil is placed on the carrier, the coil will be placed in close proximity or attached to the external walls of the measuring chamber. This injection may be performed by using a manual syringe. In the example shown in which the microfluidic chip comprises a membrane pump, the substrate is injected to an opening of the microfluidic chip that is subsequently connected to the membrane. Any excess of volume or the air in the cell chamber exits through an opening of the microfluidic chip working as a substrate outlet.

Preferably, the injection of the substrate (block 707) is done when the carrier is placed on the apparatus, but alternatively it can be made just before placing the carrier with the analyte into the apparatus.

When the analyte with the substrate agent is placed on the apparatus, a magnetic field gradient is applied (block 708) by the apparatus to the measuring chamber, the nuclei of the sample aligning with the magnetic field. In block 709 a radiofrequency pulsatile signal is applied to the measuring chamber through the radiofrequency coil, which switches the states of the nuclei, which in turn generates (block 710) a current within the coil, thus obtaining a signal from the analyte. This signal may be analysed (block 711) afterwards.

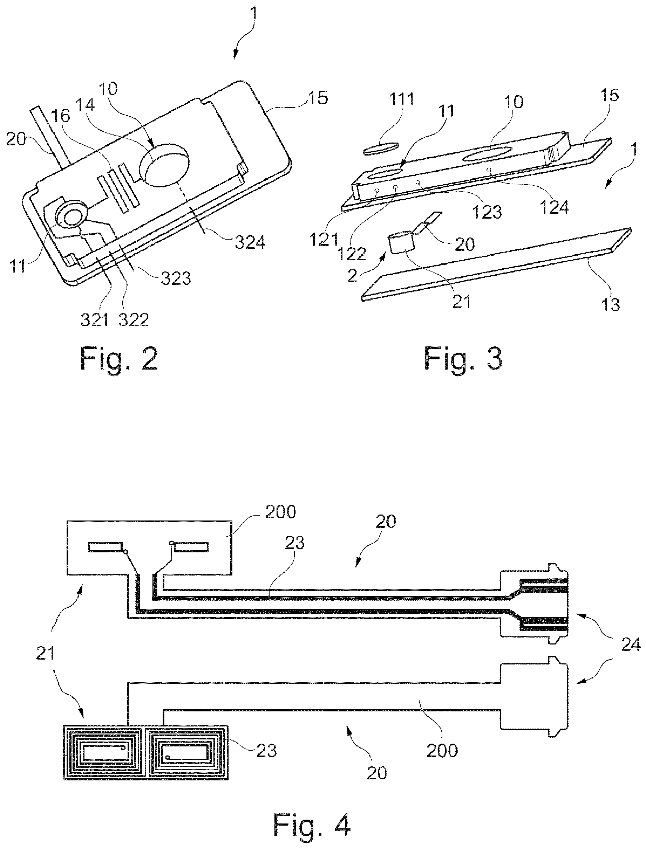

Figures 2 and 3 show an exemplary embodiment of a microfluidic chip for the method of Figure 1.

The microfluidic chip 1 comprises a measuring chamber 11 and microfluidic channels. The microfluidic chip 1 of the example comprises a PDMS body 15 and a glass platform 13. The measuring chamber 11 is configured to receive a sample matrix, or scaffold, containing the analyte or cells to be analysed.

The microfluidic chip 1 also comprises a membrane 14 in a membrane chamber 10. The membrane 14 is a membrane pump. The membrane 14 absorbs the substrate, which in the exemplary embodiment is an hyperpolarised substrate agent, introduced therein by the opening 124 and smoothly moves it to the measuring chamber 11 via a microfluidic channel connecting the membrane chamber 10 and the measuring chamber 11. The microfluidic channel connecting the membrane chamber 10 and the measuring chamber 11 comprises a serpentine 16 or capillary meandering section.

The microfluidic chip 1 shown comprises four openings 121, 122, 123, 124. These openings can be used to introduce a liquid, substance or element inside the microfluidic chip, therefore working as inlets, or to remove a liquid, substance or element from the microfluidic chip, therefore working as outlets. The injection or removal of those liquids, substances, or elements to or from the microfluidic chip can be performed by a pump, syringe, or other known methods, depending on the properties of the liquid, substance, or element. The injection or removal of these elements can be performed via connecting tubes 321, 322, 323, 324.

One of the openings 121 is configured as an outlet to extract from the measuring chamber air or substate agent from a previous operation sequence of the chip. This extraction done prior to introducing the analyte. This extraction can be done via the tube 321. One of the openings 124 is an inlet configured to inject a substate agent such a hyperpolarized substrate agent into the measuring chamber 11 through a tube 324.

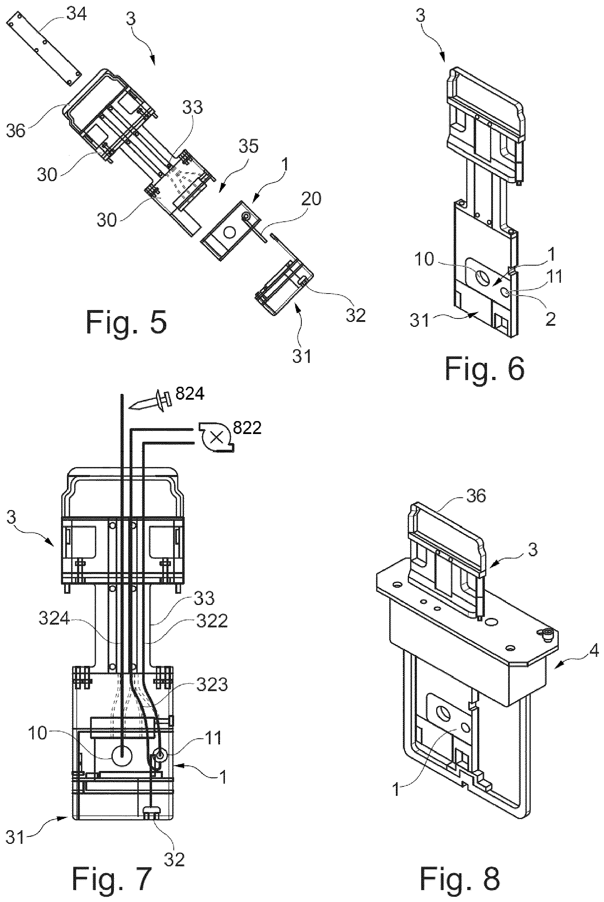

Before the injection of hyperpolarized substate to the measuring chamber through the membrane 14 in order to obtain the signal, the analyte placed on the measuring chamber 11 can be feed with continuous flow of cell media. The period of time before injecting the substate is also called the resting state. One of the openings 123 is an inlet to inject cell media into the measuring chamber 11 through a tube 323. Another of the openings 122 is configured as an outlet to extract cell media from the measuring chamber 11 through a tube 322. This flow of cell media can be kept using a pump 822, such as shown in Figure 7. This cell media opening 122 can also be used to regulate the level of the cell media prior to the substrate by emptying the measuring chamber 11 through the cell media opening 122 while letting the air get into the camber through another opening 121.The use of these openings is interchangeable. For example, the injection of cell media can be performed via the opening 124 also configured to inject the substrate agent instead than by the opening 122.

At a certain moment the substrate is injected to the measuring chamber through the substrate opening 124 and the serpentine 16 that connects it to the measuring chamber. The detection complex generates some air in the measuring chamber 11.

This air can be removed via the opening 121, the rest of the matrix being removed by the opening 122.

The microfluidic chip 1 shown comprises a sealing cover 111 to seal the measuring chamber 11. The sealing of the measuring chamber 11 is done by placing the sealing cover 111 on the measuring chamber 11. The sealing allows the introduction of substrate agent in a closed volume of the measuring chamber defined by the sealing cover. This closed volume can be filled and continuously renewed by introducing substrate agent in the opening 124, which exits by the outlet 121. This filling can be done by a syringe pump 824, which is called as push-mode. As the sample matrix, and therefore the cell culture, is sealed in the measuring chamber by the sealing cover, the flow of substrate agent can be stopped for a large period of time without producing harmful evaporation of the sample matrix. Another advantage of the sealing cover is that when the substrate agent is introduced in large quantities, or by doing a fast injection, the sealing cover avoids the flooding the measuring chamber and minimizes the risk of liquid spillage inside the NMR apparatus.

The kit of microfluidic chip 1 and carrier 3 also comprises a radiofrequency coil 2 or antenna.

The radiofrequency coil 2 is shown placed attached to the microfluidic chip 1 inside the measuring chamber 11, so that the coil 2 is in direct contact with the detection complex resultant in the chamber 11 after the injection of the substrate agent, which is preferably a hyperpolarised substrate. The placement of the coil 2 attached to the microfluidic chip 1 is preferred as it results in a more accurate measurement of the analyte via the NMR apparatus. In particular, the radiofrequency coil 2 is embedded on the body of the microfluidic chip, the coil 2 forming the walls of the measuring chamber.

As represented in Figures 3 and 4, the radiofrequency coil comprises a radiofrequency coil region 21, the radiofrequency coil region 21 being the region of the coil that generates the magnetic field, a connecting region 24, and an intermediate elongated region 20 connecting the radiofrequency coil region 21 to the connecting region 24. The connecting region 24 connects the coil to a docking system 32 of the carrier, or to a similar interface or matching circuit connecting the coil 2 and the apparatus.

The radiofrequency coil 2 is shown comprising a track 23 of copper printed on a flexible substrate 200 that is a printed circuit board (PCB). The radiofrequency coil has a saddle coil pattern. The coil and the printed circuit board are be protected with an external protective layer (not shown). The radiofrequency coil region 21 is shown having a saddle coil pattern that is printed flat, winded and adjusted to the walls of the cell chamber forming a cylinder of approximately 5 mm diameter.

Figure 4 shows the outer or top side of the radiofrequency coil 2 and the inner or bottom side of the radiofrequency coil. The copper track 23 of the coil 2 is placed on the top side of the intermediate elongated region 20 and on the inner side 212 of the radiofrequency coil region 21.

Figures 5 to 7 shows a kit comprising a carrier 3 and a microfluidic chip 1. In Figure 5, the kit is shown in an exploded view whereas in Figure 6 the kit is shown assembled, with the microfluidic chip 1 placed on the carrier 3.

The carrier comprises a chip port 35 for the placement therein of a microfluidic chip 1, electrical connection from a tuning/matching circuit for interfacing the NMR apparatus, a housing 33 for tubes and a lid 34 for the housing. This housing 33 is configured to receive tubes 324, 322, 323 connecting to the microfluidic chip 1. The carrier on Figures 5 to 7 is shown with three tubes 324, 322, 323 to connect to three openings 124, 123, 122 of the microfluidic chip. These tubes are analogue to the tubes shown in Figure 2, without the tube 321 for extracting the air or the substrate agent, which is not shown but could be placed in the carrier, due to this extraction can preferably be done before placing the microfluidic chip into the carrier,. The tube 324 connects the substrate agent inlet 124 of the chip with the exterior so that the substrate can be injected to the chip 1, for example via a syringe 824. The tubes 322, 323 connect the cell media inlets 122, 123 of the chip 1 with the exterior, so that cell media can be injected and removed from the microfluidic chip from the exterior, for example via a pump 822.

As seen in the figures, the carrier 3 comprises a main module 30 comprising the housing 33 for the tubes and a detachable module 31, the detachable module 31 comprising the docking system 32 for connecting the radiofrequency coil 2 placed on the microfluidic chip 1 to the electric supply. The detachable module 31 is shown as a locking cover. The main module 30 comprises a handle 36 to ease the placement of the carrier 3 into the probe 4.

In the exemplary carrier shown, the chip port 35 is defined by the distance between the main 30 part of the carrier 3 and the detachable module 31 of the carrier 3. Alternatively, the chip port 35 may be a housing placed on the carrier 3, this chip port being placed on the main part 30 or in the detachable module 31.

The carrier is configured so that the microfluidic chip 1 is positioned in the target area of the apparatus so that the pulses generated by the apparatus reach better the coil. In particular, the analyte and the radiofrequency coil are placed at the centre of the magnet unit of the apparatus. More particular, the carrier is configured so that the radiofrequency coil is placed so that the magnetic field generated by the coil is perpendicular to the magnetic field generated by the apparatus. As shown in Figure 6, the coil 2 is perpendicular to the direction of introduction of the carrier into the apparatus, but other configurations are also possible.

Figure 8 shows the carrier 3 comprising the microfluidic chip 1 placed in a probe 4 of the apparatus.

The present disclosure also describes a method for obtaining a signal from an analyte by nuclear magnetic resonance (NMR), the method comprising:
a) providing a microfluidic chip comprising a measuring chamber for an analyte;
b) placing an analyte in the measuring chamber of the microfluidic chip;
c) placing the microfluidic chip in a carrier, the microfluidic chip or the carrier comprising a radiofrequency coil, so that the radiofrequency coil is placed attached or in close proximity to the measuring chamber of the microfluidic chip;
d) placing the carrier in an NMR apparatus so that the measuring chamber of the microfluidic chip is accommodated in a target area of the apparatus,
   the apparatus being configured for applying magnetic field gradients in the target area, and for applying radiofrequency (RF) pulses towards the target area;
e) injecting a substrate into the measuring chamber containing the analyte ;
f) applying a magnetic field gradient to the measuring chamber; and
g) applying radiofrequency pulses to the measuring chamber, obtaining a signal from the analyte through the radiofrequency coil.

Preferably, the radiofrequency coil is placed in the carrier or in the microfluidic chip such that it is in contact or in close proximity to the measuring chamber of the microfluidic chip once the microfluidic chip is placed on the carrier. The intensity and quality of the signal received improves as the coil is placed closer to the analyte. The radiofrequency coil can also placed at close proximity from the analyte, at a distance as maximum as possible from the analyte so as the signal obtained from the analyte has an adequate intensity and quality. It is understood as "contact" between the coil and the measuring chamber to a contact between the coil and either the walls of the measuring chamber, the analyte, the sample matrix or the detection complex. It is understood as "close proximity" a distance between the coil and the analyte of less than 5 mm, more preferably less than 3 mm, more preferably less than 1 mm, more preferably less than 0.5 mm.

Although only a number of examples have been disclosed herein, other alternatives, modifications, uses and/or equivalents thereof are possible. Furthermore, all possible combinations of the described examples are also covered. Thus, the scope of the present disclosure should not be limited by particular examples but should be determined only by a fair reading of the claims that follow. If reference signs related to drawings are placed in parentheses in a claim, they are solely for attempting to increase the intelligibility of the claim and shall not be construed as limiting the scope of the claim.

## Claims

1. A method for obtaining a signal from an analyte by nuclear magnetic resonance (NMR), the method comprising:
a) providing a microfluidic chip comprising a measuring chamber for an analyte;
b) placing an analyte in the measuring chamber of the microfluidic chip;
c) placing the microfluidic chip in a carrier, the microfluidic chip or the carrier comprising a radiofrequency coil, so that the radiofrequency coil is placed inside the measuring chamber of the microfluidic chip;
d) placing the carrier in an NMR apparatus so that the measuring chamber of the microfluidic chip is accommodated in a target area of the apparatus,
the apparatus being configured for applying magnetic field gradients in the target area, and for applying radiofrequency (RF) pulses towards the target area;
e) injecting a substrate into the measuring chamber containing the analyte;
f) applying a magnetic field gradient to the measuring chamber; and
g) applying radiofrequency pulses to the measuring chamber, obtaining a signal from the analyte through the radiofrequency coil.

2. The method according to claim 1, wherein the apparatus comprises a probe, the probe comprising a seat configured for accommodating the carrier, such that the measuring chamber of the microfluidic chip and the radiofrequency coil are placed in the target area of the apparatus after the carrier is placed in the probe of the apparatus.

3. The method according to any of claims 1 or 2, wherein the carrier is placed in the apparatus in a position such that a magnetic field generated by the radiofrequency coil is perpendicular to a magnetic field generated by the apparatus.

4. The method according to any of claims 1 to 3, wherein the substrate is injected into a membrane pump of the microfluidic chip, the membrane pump being fluidically connected to the measuring chamber, the membrane pump regulating the flow of substate into the measuring chamber.

5. A carrier for a microfluidic chip, the carrier comprising a microfluidic chip port for the placement therein of a microfluidic chip, the carrier also comprising an electrical connection from a tuning/matching circuit for interfacing the NMR apparatus, wherein the carrier is adapted for its insertion in an NMR apparatus.

6. The carrier according to claim 5, wherein the carrier comprises a housing for tubes connecting openings of the microfluidic chip with the outside of the carrier.

7. The carrier according to any of claims 5 or 6, wherein the carrier comprises a main module and a detachable module, the detachable module comprising a docking connector for connecting the radiofrequency coil with a power supply, the chip port being defined by the distance between the main module of the carrier and the detachable module of the carrier.

8. The carrier according to claim 7, wherein the detachable module of the carrier is a locking cover to releasably lock the microfluidic chip in the chip port.

9. A kit comprising a carrier according to any of claims 5 to 8 and a microfluidic chip comprising a measuring chamber for the placement therein of an analyte.

10. A kit, according to claim 9, wherein the microfluidic chip comprises a radiofrequency coil, the radiofrequency coil being attached to the microfluidic chip.

11. A kit, according to claim 10, wherein the radiofrequency coil is embedded in the microfluidic chip.

12. A kit, according to any of claims 10 or 11, wherein the radiofrequency coil is placed inside de measuring chamber.

13. A kit, according to any of claims 10 to 12, wherein the radiofrequency coil comprises a cylindrical radiofrequency region and wherein the measuring chamber of the microfluidic chip is a cylindrical chamber.

14. A kit, according to any of claims 9 to 13, wherein the microfluidic chip comprises a membrane pump, an opening configured for the injection of a substrate being connected to the membrane pump, the membrane pump being fluidically connected to the measuring chamber by a fluidic channel, so that the membrane pump inflates upon injection of the substrate and subsequently deflates, delivering the injected substrate towards the measuring chamber though said fluidic channel.

15. A kit, according to any of claims 9 to 14, wherein the microfluidic chip comprises more than one measuring chambers.
